Europäisches Patentamt

European Patent Office

Office européen des brevets

(11) Publication number: **0 534 411 A1**

# EUROPEAN PATENT APPLICATION

(21) Application number: **92116293.9**

(22) Date of filing: **23.09.92**

(51) Int. Cl.5: **H03H 9/02**

(30) Priority: **26.09.91 JP 248028/91**
**02.09.92 JP 234570/92**

(43) Date of publication of application:
**31.03.93 Bulletin 93/13**

(84) Designated Contracting States:
**DE FR GB NL**

(71) Applicant: **SUMITOMO ELECTRIC INDUSTRIES,
LIMITED**
**5-33, Kitahama 4-chome Chuo-ku**
**Osaka(JP)**

(72) Inventor: **Nakahata, Hideaki, c/o Itami Works
of Sumitomo**
**Electric Ind., Ltd., 1-1, Koyakita 1-chome**
**Itami-shi, Hyogo(JP)**
Inventor: **Shikata, Shinichi, c/o Itami Works of
Sumitomo**
**Electric Ind., Ltd., 1-1, Koyakita 1-chome
Itami-shi, Hyogo(JP)**
Inventor: **Hachigo, Akihiro, c/o Itami Works of
Sumitomo**
**Electric Ind., Ltd., 1-1, Koyakita 1-chome
Itami-shi, Hyogo(JP)**
Inventor: **Fujimori, Naoji, c/o Itami Works of
Sumitomo**
**Electric Ind., Ltd., 1-1, Koyakita 1-chome
Itami-shi, Hyogo(JP)**
Inventor: **Higaki, Kenjiro, c/o Itami Works of
Sumitomo**
**Electric Ind., Ltd., 1-1, Koyakita 1-chome
Itami-shi, Hyogo(JP)**

(74) Representative: **Herrmann-Trentepohl,
Werner, Dipl.-Ing. et al
Herrmann-Trentepohl, Kirschner, Grosse,
Bockhorni & Partner Forstenrieder Allee 59
W-8000 München 71 (DE)**

(54) **Surface acoustic wave device.**

(57) Disclosed herein is a surface acoustic wave device having a high electromechanical coupling factor and a high phase velocity, which can stably maintain its characteristics against external environment. The surface acoustic wave device includes a substrate (1), a diamond thin film (2) formed on the substrate (1), interdigital electrodes (3) and a piezoelectric layer (4) formed on the diamond thin film (2), and a layer (5) made of a diamond-like carbon film or diamond covering the piezoelectric layer (4). The layer (5) protects a device center portion defined by the piezoelectric layer (4) and the interdigital electrodes (3), and improve the electromechanical coupling factor of the device.

FIG.5

## BACKGROUND OF THE INVENTION

### Field of the Invention

The present invention relates to a surface acoustic wave device which can be applied to a high frequency filter, for example, and more particularly, it relates to a surface acoustic wave device which comprises a layer of diamond or a diamond-like carbon film combined with a piezoelectric layer.

### Description of the Background Art

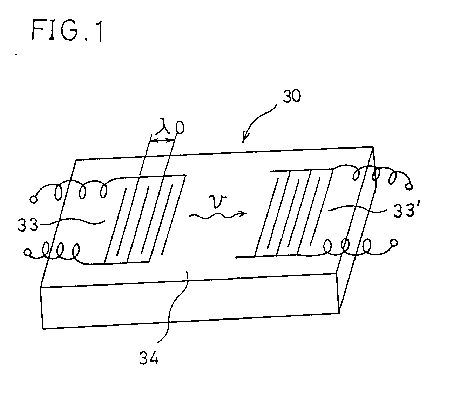

A surface acoustic wave device, which is an electromechanical transducer device utilizing surface waves propagated on the surface of an elastic body, has a general structure shown in Fig. 1, for example. In such a surface acoustic wave device 30, a piezoelectric phenomenon which is caused by a piezoelectric member 34 is utilized for exciting surface waves. When an electric signal is applied to interdigital electrodes 33 which are provided on the piezoelectric member 34, the piezoelectric member 34 is distorted to generate surface acoustic waves, which in turn are propagated along the piezoelectric member 34 and fetched in other interdigital electrodes 33' as an electric signal. Assuming that $\lambda_0$ represents the electrode period in the interdigital electrodes 33 and 33' and v represents the phase velocity for the surface acoustic waves in relation to frequency characteristics, this device has a bandpass characteristic with a center frequency $f_0$, which is expressed as $f_0 = v/\lambda_0$.

The surface acoustic wave device can be miniaturized with a small number of components, while it is possible to input/output signals on a surface wave propagation path. This device can be applied to a filter, a delay line, an oscillator, a resonator, a convolver, a correlator etc. In particular, a surface acoustic wave filter has been practically applied to an intermediate frequency filter for a television for a long time, while the same is now being applied to filters for VTR and various communication devices such as an automobile telephone and a portable telephone.

A conventional surface acoustic wave device comprises a single-crystalline piezoelectric member of $LiNbO_3$ or $LiTaO_3$ and interdigital electrodes formed thereon. On the other hand, there has recently been employed a surface acoustic wave device comprising a piezoelectric thin film of ZnO or the like which is formed on a substrate of glass etc. by a technique such as sputtering.

However, it is difficult to prepare a device which is employed in a high frequency region (GHz band) through the aforementioned conventional structure. In the device having only a single-crystalline piezoelectric member and interdigital electrodes formed thereon, it is difficult to attain a high center frequency $f_0$ exceeding 1 GHz, since the phase velocity v for surface acoustic waves is small. On the other hand, the piezoelectric film of ZnO or the like which is formed on a glass substrate for increasing the frequency $f_0$ is generally a polycrystalline substance having an orientation property. Thus, the device employing this piezoelectric film is insuitable for use in a high frequency band exceeding 100 MHz, due to extreme loss which is caused by scattering.

In order to attain a higher center frequency in relation to frequency characteristics of the surface acoustic wave device, it is necessary to reduce the period $\lambda_0$, i.e., electrode spacing of the interdigital electrodes, or increase the phase velocity v for the surface acoustic waves, as suggested by the above expression.

However, reduction of the electrode spacing for attaining a higher center frequency is restricted by a fine working technique employing lithography etc. Thus, there has been studied a technique of increasing the phase velocity for surface waves.

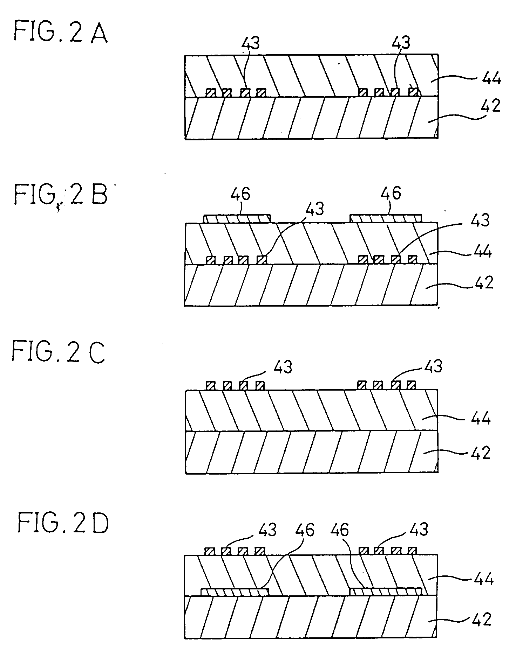

Japanese Patent Publication No. 54-38874 (1979) discloses a device comprising a sapphire layer which is provided between a substrate and a piezoelectric film. In such a sapphire layer, acoustic waves are propagated at a higher velocity than that in the piezoelectric film. On the other hand, Japanese Patent Laying-Open Nos. 64-62911 (1989) by Imai et al. and 3-198412 (1991) by Nakahata et al. disclose devices comprising a diamond layer and a piezoelectric layer which is stacked on the diamond layer for increasing the propagation velocities v for surface acoustic waves. Figs. 2A to 2D show exemplary devices which are disclosed in these gazettes.

Referring to Fig. 2A, a piezoelectric layer 44 is formed on a diamond layer 42, and interdigital electrodes 43 are provided between these layers. Referring to Fig. 2B, short-circuit electrodes 46 are provided on the piezoelectric layer 44 of the device shown in Fig. 2A. Referring to Fig. 2C, a piezoelectric layer 44 is formed on a diamond layer 42, and interdigital electrodes 43 are provided on the piezoelectric layer 44. Referring to Fig. 2D, short-circuit electrodes 46 are provided between the piezoelectric layer 44 and the diamond layer 42 of the device shown in Fig. 2C.

In Japanese Patent Laying-Open No. 3-198412 (1991), thicknesses of the piezoelectric layer made of ZnO and excitation modes are studied in order to obtain high propagation velocities and high electromechanical coupling factors as to the devices shown in Figs. 2A to 2D.

Further, Japanese Patent Laying-Open No. 1-103310 (1991) by Nakahata et al. discloses a surface acoustic wave device comprising a piezoelectric layer which is deposited on a diamond-like carbon film layer in order to increase the phase velocity v. In the device disclosed in this gazette, a diamond-like carbon film layer is employed in place of the diamond layer in each of the devices shown in Figs. 2A to 2D.

As hereinabove described, a surface acoustic wave filter is applied to filters for various communication devices, and particularly studied as a high frequency filter for a portable telephone or the like. It is well known in the art that a portable telephone is used under such various environment that a device which is built in this telephone is influenced by moisture, impurities and the like. Thus, a surface acoustic wave device employed for a portable telephone must maintain stable characteristics in the environment.

Further, it is desired that a filter which is applied to the field of mobile communication etc. in relation to a surface acoustic wave device can be employed in a higher frequency range of 1.5 to 3 GHz. In order to implement such a filter, required is a device structure which can perform electromechanical transduction in high efficiency with a high phase velocity v.

SUMMARY OF THE INVENTION

An object of the present invention is to provide a surface acoustic wave device which can maintain stable performance with respect to environment.

Another object of the present invention is to provide a practical surface acoustic wave device which can be employed in a high frequency range exceeding 1 GHz.

A surface acoustic wave device according to the present invention includes a first layer which is essentially made of at least either diamond or a diamond-type carbon film, a piezoelectric layer which is formed on the first layer, a second layer, being essentially made of at least either diamond or a diamond-type carbon film, which is formed on the piezoelectric layer, and an electrode which is combined with the piezoelectric layer for electromechanical transduction between electric signals and surface acoustic waves.

According to the present invention, the piezoelectric layer is held between the first and second layers. Such a sandwich structure protects a device center portion which is defined by the piezoelectric layer and the electrode, and brings high electromechanical coupling.

The diamond-like carbon film forming the first or second layer is also called i-carbon. This diamond-like carbon film has been found in the process of study on vapor deposition of diamond, and its material has been investigated and clarified by many researchers. Although there is no established theory as to definition of the diamond-like carbon film as a substance, this film remarkably differs from diamond, graphite, amorphous carbon and the like, and has the following properties:

(1) This film is a composite of carbon and hydrogen, with a smaller content of hydrogen.

(2) This film is in an amorphous state.

(3) This film is extremely harder at least in comparison with general metals.

(4) This film is an electrical insulator.

(5) This film transmits light.

While diamond has hardness of up to 10,000 (Hv), the diamond-like carbon film has hardness of 1,000 to 5,000 (Hv), for example.

The diamond-like carbon film can be prepared by a vapor deposition process such as plasma CVD, ion bean deposition or sputtering, similarly to synthesis of diamond.

According to the present invention, the first and second layers, which are preferably made of diamond or diamond-like carbon films, may contain small amounts of impurities. In order to improve the phase velocity and efficiency of electromechanical transduction, the first layer and/or the second layer is preferably made of diamond.

However, a diamond-like carbon film can be vapor-deposited under the room temperature, although a temperature of at least 700°C is required for vapor deposition of diamond. Thus, the diamond-like carbon film extremely spreads the range of materials selected for a substrate to be provided thereon with such a film. Since a large-area diamond-like carbon film can be easily obtained and its thickness can be controlled in high accuracy, the second layer is preferably prepared from a diamond-like carbon film which is formed on a piezoelectric layer, in order to control the center frequency in high accuracy. Further, a layer of the diamond-like carbon film has a smoother surface as compared with that of diamond.

According to the present invention, the first layer may be provided on a substrate. The material for the substrate to be provided with the first layer, which is essentially made of diamond, is not particularly restricted but can be prepared from a semiconductor material such as Si or GaAs, a metal such as Mo or W, or an inorganic material such as $LiNbO_3$, for example. On the other hand, it is possible to apply a substrate in a wider range as compared with diamond, in order to form the first layer which is essentially made of a diamond-like carbon film. Such a substrate includes that of an organic compound such as synthetic resin, for example.

The diamond layer provided on a substrate may be either single-crystalline or polycrystalline. A diamond layer formed by vapor deposition generally has a polycrystalline structure.

Further, the first layer may be formed by a substrate which is essentially made of single-crystalline diamond. Such a substrate of single-crystalline diamond is preferably employed in order to improve the phase velocity and electromechanical coupling. Such a substrate can be made of natural diamond, or synthetic diamond which is prepared by extra-high pressure synthesis.

The diamond layer can be formed on a substrate by CVD such as thermal CVD, plasma CVD, microwave CVD, photo CVD or laser CVD, sputtering, or ion beam deposition. A diamond-like carbon film can also be formed on a substrate in a similar manner to diamond.

In more concrete terms, a method of decomposing/exciting a raw material gas for vapor-depositing diamond may be carried out by (1) a method of heating a thermoionic emission material to a temperature of at least 1500 K thereby activating the raw material gas, (2) a method of utilizing discharge by a DC-, AC- or microwave electric field, (3) a method of utilizing ion bombardment, (4) a method of applying a beam such as a laser beam, or (5) a method of burning the raw material gas, for example.

A raw material employed for vapor-depositing diamond or a diamond-like carbon film is generally prepared from a compound containing carbon. Such a compound is preferably combined with gaseous hydrogen. Further, a compound containing oxygen and/or inert gas is added to the raw material gas at need.

The compound containing carbon can be selected from paraffinic hydrocarbons such as methane, ethane, propane and butane, olefinic hydrocarbons such as ethylene, propylene and butylene, acetylenic hydrocarbons such as acetylene and allylene, diolefinic hydrocarbon such as butadiene, alicyclic hydrocarbons such as cyclopropane, cyclobutane, cyclopentane and cyclohexane, aromatic hydrocarbons such as cyclobutadiene, benzene, toluene, xylene and naphthalene, ketones such as acetone, diethylketone and benzophenone, alcohols such as methanol and ethanol, amines such as trimethylamine and triethylamine, carbon dioxide and carbon monoxide, for example. One of these elements may be independently employed, or two or more such elements may be combined with each other. The compound containing carbon may be prepared from a substance which is made of only carbon atoms of graphite, lime or coke.

The compound containing oxygen to be added to the raw material gas is preferably prepared from oxygen, water, carbon monoxide, carbon dioxide or hydrogen peroxide, which is easy to obtain.

The inert gas which can be added to the raw material gas can be prepared from argon, helium, neon, krypton, xenon or radon, for example.

According to the present invention, the piezoelectric layer can be mainly composed of ZnO, $AlN$, $Pb(Zr,Ti)O_3$, $(Pb,La)(Zr,Ti)O_3$, $LiTaO_3$, $LiNbO_3$, $SiO_2$, $Ta_2O_5$, $Nb_2O_5$, BeO, $Li_2B_4O_7$, $KNbO_3$, ZnS, ZnSe or CdS. The piezoelectric layer may be either single-crystalline or polycrystalline, while a single-crystalline piezoelectric material is more preferably employed due to small scattering of surface waves, in order to employ the device in a higher frequency range. A piezoelectric layer of ZnO, $AlN$ or $Pb(Zr,Ti)O_3$ can be formed by CVD or sputtering.

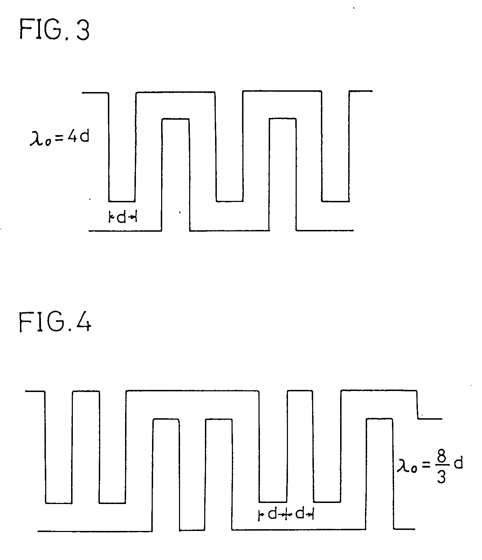

According to the present invention, the electrodes for making electromechanical transduction between electric signals and surface acoustic waves typically correspond to interdigital electrodes or electrodes called an interdigital transducer (IDT). The interdigital electrodes have a shape shown in Fig. 3 or 4, for example. The interdigital electrodes shown in Fig. 3 comprise a pair of electrode members provided with poles, each having a width d, which are integrally formed with each other with electrode spacing of 3d. Such electrode members are opposed to each other so that like and unlike poles are alternately arranged. These are the most standard interdigital electrodes, which excite surface acoustic waves having a wavelength $\lambda_0$ of 4d. On the other hand, the interdigital electrodes shown in Fig. 4 comprise a pair of opposite electrode members provided with pairs of poles each having a width d. Each pair of the poles are adjacent to each other with a spacing d, and such pairs of the poles are arranged with spacings of 5d. The interdigital electrodes shown in Fig. 4 excite surface acoustic waves having a wavelength $f_0$ of 8d/3.

It is possible to prepare interdigital electrodes having electrode spacing of about 1.2 $\mu$m by photolithography. The material for the electrodes is preferably prepared from a metal having small resistivity, such as Au, Ag or $Al$ which can be deposited at a low temperature, or Ti, W or Mo having a high melting point. $Al$ or Ti is preferable in view of easiness in formation of the electrodes, while W or Mo is preferable in view of adhesion to diamond. The interdigital electrodes may be made of a single metal material, or two or more metal layers, such as an $Al$ layer formed on a Ti layer, for example, may be combined with each other.

In formation of the interdigital electrodes, a metal film of the aforementioned material is formed on a prescribed position. Then, a resist film is formed on the metal film, and a mask prepared by forming a pattern for the interdigital electrodes on a transparent flat panel of glass or the like is provided on the resist film, which in turn is exposed with a mercury lamp or the like. Then the resist film is developed to obtain a resist pattern. Alternatively, the resist film may be directly exposed with an electron beam.

After the resist pattern is formed, the metal film is worked into a prescribed Shape by etching. An alkaline solution such as a sodium hydroxide solution or an acid solution such as nitrate is employed for etching a film of a metal having a low melting point such as $A\ell$, while a mixed solution of hydrofluoric acid and nitrate is employed for etching a film of a metal having a high melting point. On the other hand, it is possible to employ reactive ion etching using a gas such as $BC\ell_3$ for working the metal film.

According to the present invention, on the other hand, the electrodes can be made of conductive diamond. Such conductive diamond can be formed by a method of vapor-depositing diamond with supply of an impurity such as B, $A\ell$, P or S, a method of doping insulating diamond with such an impurity by ion implantation, a method of applying an electron beam to insulating diamond for introducing a lattice defect thereinto, or a method of hydrogenating insulating diamond.

According to the present invention, the interdigital electrodes can be formed between the first layer and the piezoelectric layer, or between the piezoelectric layer and the second layer. In addition, the interdigital electrodes can be formed with a short-circuit electrode. When the interdigital electrodes are provided between the first layer and the piezoelectric layer, the short-circuit electrode can be formed between the piezoelectric layer and the second layer and/or on the second layer. When the interdigital electrodes are formed between the piezoelectric layer and the second layer, on the other hand, the short-circuit electrode can be provided between the first layer and the piezoelectric layer and/or on the second layer.

When the piezoelectric film is formed on a substrate whose material has a sound velocity higher than that of the piezoelectric material, a plurality of types of surface acoustic waves, which are propagated at different velocities v, are excited. In this case, excitation modes are defined as a zero-order mode, a first mode, a secondary mode, a tertiary mode, ... successively from a smaller velocity side. According to the present invention, a surface acoustic wave device having interdigital electrodes which are provided between a first layer and a piezoelectric layer is applicable as a device having an excitation structure of a zero-order mode. If the second layer is sufficiently smaller in thickness than the piezoelectric layer, however, the surface acoustic wave device having the interdigital electrodes provided between the first layer and the piezoelectric layer can be applied as a device having an excitation structure of a first mode.

On the other hand, a surface acoustic wave device having interdigital electrodes which are formed between a piezoelectric layer and a second layer can be applied as a device having an excitation structure of a first mode.

According to the present invention, it is possible to provide a surface acoustic wave device having a phase velocity of at least about 7,000 m/s in a zero-order mode and an electromechanical coupling factor of at least 0.3 %. The electromechanical coupling factor is an index expressing transduction efficiency for transducing electric energy to mechanical energy. According to the present invention, further, it is possible to provide a surface acoustic wave device having a phase velocity of at least about 9,000 m/s in a first mode and an electromechanical coupling factor of at least 0.3 %.

In the surface acoustic wave device according to the present invention, as hereinabove described, a second layer of a diamond-like carbon film or diamond is formed on a piezoelectric layer. The second layer is an electrical insulator, which is extremely hard. Thus, the second layer serves as a passivation film for protecting a device center portion which is defined by the piezoelectric layer and interdigital electrodes against external environment. The second layer can extremely reduce influences exerted by moisture from the external environment and impurities, whereby characteristics of the device are stably maintained for a long time.

As understood from the following Examples, the inventors have found that it is possible to increase the electromechanical coupling factor and the phase velocity v, particularly the electromechanical coupling factor, in the device having the sandwich structure in which a piezoelectric layer and interdigital electrodes are held between the first and second layers as compared with a device having no second layer, by appropriately setting thicknesses of the piezoelectric layer and the second layer. Thus, according to the present invention, it is possible to provide a surface acoustic wave device having a high center frequency, which can make electromechanical transduction in higher efficiency than a conventional surface acoustic wave device provided with no second layer. Thus, the second layer not only serves as a passivation film, but improves electromechanical transduction performance of the surface acoustic wave device.

The foregoing and other objects, features, aspects and advantages of the present invention will become more apparent from the following detailed description of the present invention when taken in conjunction with the accompanying drawings.

## BRIEF DESCRIPTION OF THE DRAWINGS

Fig. 1 is a perspective view typically showing a general structure of a surface acoustic wave device;

Figs. 2A to 2D are sectional views showing conventional surface acoustic wave devices;

Fig. 3 is a plan view showing an exemplary shape of interdigital electrode;

Fig. 4 is a plan view showing another exemplary shape of interdigital electrode;

Fig. 5 is a sectional view showing a surface acoustic wave device prepared according to Example 1 of the present invention;

Fig. 6 is a sectional view showing a conventional surface acoustic wave device prepared as comparative example;

Fig. 7 is a sectional view showing a surface acoustic wave device prepared according to Example 2 of the present invention;

Fig. 8 is a sectional view showing a surface acoustic wave device prepared according to Example 3 of the present invention;

Fig. 9 is a sectional view showing a surface acoustic wave device prepared according to Example 4 of the present invention;

Fig. 10 is a sectional view showing a surface acoustic wave device prepared according to Example 5 of the present invention;

Fig. 11 is a sectional view showing a surface acoustic wave device prepared according to Example 6 of the present invention;

Fig. 12 is a sectional view showing a surface acoustic wave device prepared according to Example 7 of the present invention;

Fig. 13 is a sectional view showing a surface acoustic wave device prepared according to Example 8 of the present invention;

Fig. 14 is a sectional view showing a surface acoustic wave device prepared according to Example 9 of the present invention;

Fig. 15 illustrates the relation between the thickness of a second layer of diamond and the electromechanical coupling factor in the surface acoustic wave device according to Example 3;

Fig. 16 illustrates the relation between the thickness of a second layer of diamond and the electromechanical coupling factor in the surface acoustic wave device according to Example 5;

Fig. 17 illustrates the relation between the thickness of a second layer of diamond and the electromechanical coupling factor in the surface acoustic wave device according to Example 6;

Fig. 18 illustrates the relation between the thickness of a second layer of diamond and the electromechanical coupling factor in the surface acoustic wave device according to Example 7;

Fig. 19 illustrates the relation between the thickness of a second layer of diamond and the electromechanical coupling factor in the surface acoustic wave device according to Example 8;

Fig. 20 illustrates the relation between the thickness of a second layer of diamond and the electromechanical coupling factor in the surface acoustic wave device according to Example 9;

Fig. 21 illustrates the relation between the thickness of the second layer of diamond and the phase velocity in each of the surface acoustic wave devices according to Examples 3, 5, 6, 7, 8 and 9;

Fig. 22 illustrates the relation between the thickness of a second layer of diamond and the electromechanical coupling factor in the surface acoustic wave device according to Example 2;

Fig. 23 illustrates the relation between the thickness of a second layer of diamond the electromechanical coupling factor in another surface acoustic wave device according to Example 3, having a piezoelectric layer which is different in thickness from that shown in Fig. 15;

Fig. 24 illustrates the relation between the thickness of a second layer of diamond and the electromechanical coupling factor in another surface acoustic wave device according to Example 4;

Fig. 25 illustrates the relation between the thickness of a second layer of diamond and the electromechanical coupling factor in another surface acoustic wave device according to Example 5 having a piezoelectric layer which is different in thickness from that shown in Fig. 16;

Fig. 26 illustrates the relation between the thickness of a second layer of diamond the electromechanical coupling factor in another surface acoustic wave device according to Example 6 having a piezoelectric layer which is different in thickness from that shown in Fig. 17;

Fig. 27 illustrates the relation between the thickness of a second layer of diamond and the electromechanical coupling factor in another surface acoustic wave device according to Example 7 having a piezoelectric layer which is different in thickness form that shown in Fig. 18;

Fig. 28 illustrates the relation between the thickness of a second layer of diamond and the electromechanical coupling factor in another surface acoustic wave device according to Example 8 having a piezoelectric layer which is different in thickness from that shown in Fig. 19;

Fig. 29 illustrates the relation between the thickness of a second layer of diamond and the electromechanical coupling factor in another surface acoustic wave device according to Example 9 having a piezoelectric layer which is different in thickness from that shown in Fig. 20;

Fig. 30 illustrates the relation between the thickness of the second layer of diamond and the phase velocity in each of other surface acoustic wave devices according to Examples 2 to 9 with a mode different from that shown in Fig. 21 as to the thickness of the piezoelectric layer; and

Figs. 31A and 31B are sectional views showing exemplary surface acoustic wave devices employing diamond substrates according to the present invention.

DESCRIPTION OF THE PREFERRED EMBODIMENTS

Example 1

An Si substrate of 10 by 10 by 1 mm was prepared and set in a plasma CVD apparatus. A reaction chamber was evacuated, to introduce a mixed gas of $H_2:CH_2 = 200:1$ into the same. A diamond thin film of 25 $\mu$m in thickness was grown on the substrate by plasma CVD under conditions of a pressure of about 40 Torr in the reaction chamber, a substrate temperature of 850°C and microwave power of 400 W.

Then, the diamond thin film was left in the atmosphere at 450°C for 10 minutes, to be improved in resistance value. Then, the surface of the diamond thin film was polished, and thereafter an Aℓ layer of 500 Å in thickness was deposited by resistance welding. Then, interdigital electrodes having electrode spacing of 2 $\mu$m were formed from the Aℓ layer by photolithography.

Then, a ZnO polycrystalline substance was sputtered by magnetron sputtering with a mixed gas of $Ar:O_2 = 1:1$ under conditions of a sputtering output of 150 W and a substrate temperature of 380°C, to deposit a ZnO film of 0.93 $\mu$m in thickness.

Then, a diamond-like carbon film layer was formed on the ZnO film by plasma CVD. In order to form this diamond-like carbon film layer, methane gas was introduced into the reaction chamber of the plasma CVD apparatus at about 5 sccm, to maintain the pressure in the reaction chamber at about 0.002 Torr. The substrate temperature was set at 25°C, and discharge was made with power density of 2 W/cm$^2$, to form a plasma state. Thus, a diamond-like carbon film layer of 400 Å in thickness was formed in about 0.5 h.

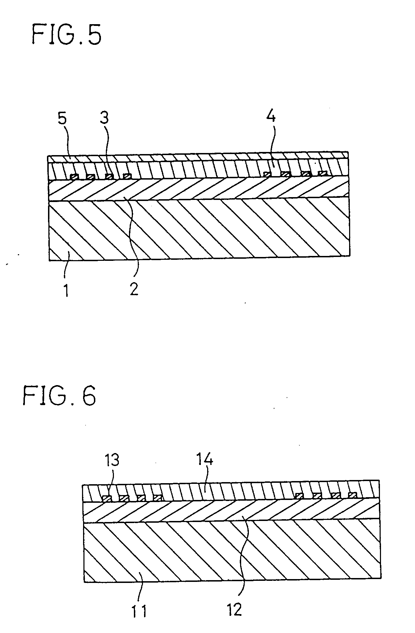

Fig. 5 is a sectional view showing a surface acoustic wave device formed in the aforementioned manner. Referring to Fig. 5, a diamond thin film 2 is formed on an Si substrate 1. Interdigital electrodes 3 are formed on the diamond thin film 2, and a ZnO thin film 4 is formed thereon. A diamond-like carbon film layer 5 is formed on the ZnO thin film 4.

Fig. 6 shows a surface acoustic wave device prepared as comparative example, which was provided with no diamond-like carbon film layer. Referring to Fig. 6, a diamond thin film 12 is formed on an Si substrate 11, while interdigital electrodes 13 and a ZnO thin film 14 are formed on the diamond thin film 12. The comparative surface acoustic wave device was prepared in a similar manner to Example 1, except that no diamond-like carbon film layer was formed.

Dilute hydrochloric acid of 5 % was dripped on the surface of each of the aforementioned surface acoustic wave devices, and the surface was washed after 5 minutes, for evaluation of filter characteristics. The inventive surface acoustic wave device shown in Fig. 5 exhibited no characteristic changes, while the comparative surface acoustic wave device shown in Fig. 6 lost filter characteristics since the ZnO thin film was etched. Thus, the diamond-like carbon film layer formed on the piezoelectric layer protects the surface acoustic wave device against external environment.

Example 2

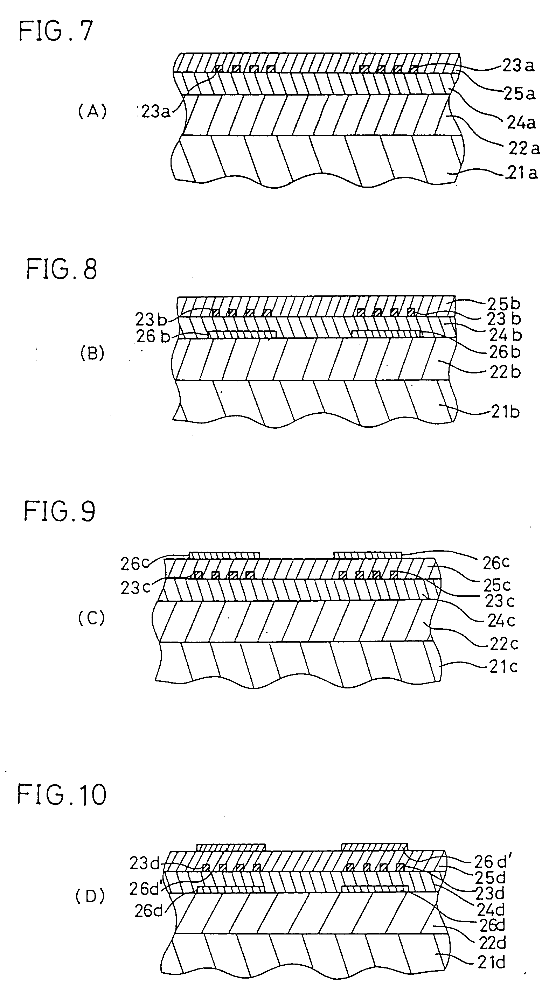

A surface acoustic wave device shown in Fig. 7 was prepared. Referring to Fig. 7, a diamond thin film 22a is formed on an Si substrate 21a, and a ZnO thin film 24a is formed on the diamond thin film 22a. Interdigital electrodes 23a are formed on the ZnO thin film 24a, and a diamond layer 25a is formed thereon.

In the surface acoustic wave device having the aforementioned structure, the diamond thin film 22a and the diamond layer 25a were formed by plasma CVD under conditions similar to those in Example 1. The diamond film 22a was about 25 $\mu$m in thickness, while the diamond layer 25a was varied in thickness for investigation of characteristic changes. The ZnO thin film 24a serving as a piezoelectric layer and the interdigital electrodes 23a were formed in a similar manner to Example 1.

The structure of the surface acoustic wave device shown in Fig. 7 is hereinafter referred to as a structure A. Characteristic changes caused by variation in thickness of the diamond layer 25a are described later.

Example 3

A surface acoustic wave device shown in Fig. 8 was prepared. Referring to Fig. 8, a diamond thin film 22b is formed on an Si substrate 21b. Short-circuit electrodes 26b are formed on the diamond thin film 22b, and a ZnO thin film 24b is formed thereon. Interdigital electrodes 23b are formed on the ZnO thin film 24b, and a diamond layer 25b is deposited thereon.

In the device shown in Fig. 8, the diamond thin film 22b and the diamond layer 25b were formed by plasma CVD under conditions similar to those in Example 1. The ZnO thin film 24b and the interdigital electrodes 23b were also formed under conditions similar to those in Example 1. On the other hand, the short-circuit electrodes 26b were formed by depositing an Aℓ layer of 500 Å in thickness on a polished surface of the diamond thin film 22b by resistance heating, and thereafter performing photolithography. In the device shown in Fig. 8, the short-circuit electrodes 26b were formed to cover regions provided with the interdigital electrodes 23b, in order to improve excitation efficiency.

The structure of the surface acoustic wave device shown in Fig. 8 is hereinafter referred to as a structure B. Characteristic changes caused by variation in thickness of the diamond layer 25b are described later.

Example 4

A surface acoustic wave device shown in Fig. 9 was prepared. Referring to Fig. 9, a diamond thin film 22c is formed on an Si substrate 21b, and a ZnO thin film 24c is formed thereon. Interdigital electrodes 23c are formed on the ZnO thin film 24c, and a diamond layer 25c is formed thereon to cover the interdigital electrodes 23c and the ZnO thin film 24c. Short-circuit electrodes 26c are formed on the diamond layer 25c.

In the device shown in Fig. 9, the respective layers and electrodes were formed under conditions similar to those in Examples 1 to 3. The structure of the surface acoustic wave device shown in Fig. 9 is hereinafter referred to as a structure C. Characteristic changes caused by variation in thickness of the diamond layer 25c are described later.

Example 5

A surface acoustic wave device shown in Fig. 10 was prepared. Referring to Fig. 10, a diamond thin film 22d is formed on an Si substrate 21d. Short-circuit electrodes 26d are formed on the diamond thin film 22d, and a ZnO thin film 24d is deposited thereon. Interdigital electrodes 23d are formed on the ZnO thin film 24d, and a diamond layer 25d is deposited thereon. Short-circuit electrodes 26d' are further provided on the diamond layer 25d, to cover regions provided with the interdigital electrodes 23d. This device was also formed under conditions similar to those in Examples 1 to 3. The structure of the surface acoustic wave device shown in Fig. 10 is hereinafter referred to as a structure D. Characteristic changes caused by variation in thickness of the diamond layer 25d are described later.

Example 6

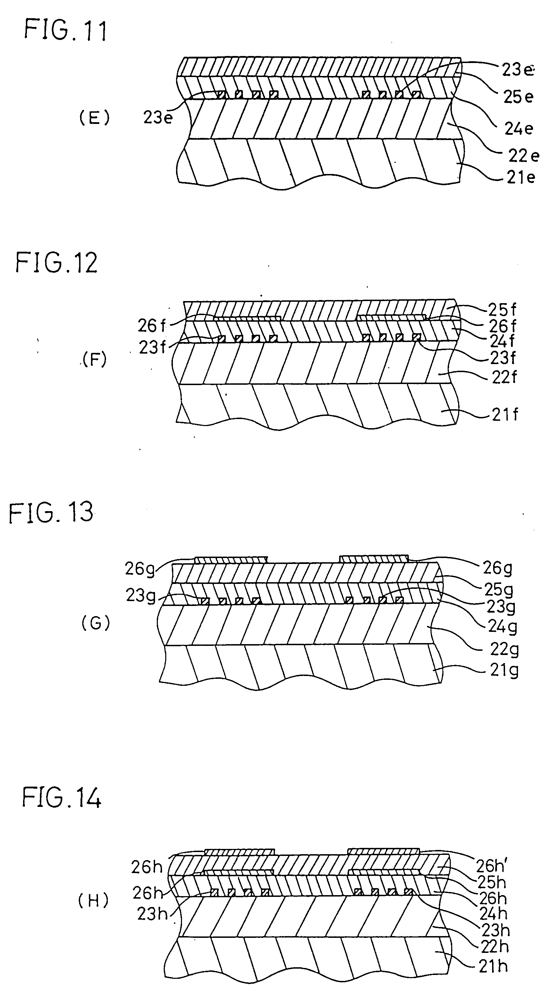

A surface acoustic wave device shown in Fig. 11 was prepared. Referring to Fig. 11, a diamond thin film 22e, a ZnO thin film 24e and a diamond layer 25e are successively deposited on an Si substrate 21e, while interdigital electrodes 23e are held between the diamond thin film 22e and the ZnO thin film 24e. In this structure, the respective layers and electrodes were formed under conditions similar to those in Example 1. The structure of the surface acoustic wave device shown in Fig. 11 is hereinafter referred to as a structure E. Characteristic changes caused by variation in thickness of the diamond layer 25e are described later.

Example 7

A surface acoustic wave device shown in Fig. 12 was prepared. Referring to Fig. 12, a diamond thin film 22f is formed on an Si substrate 21f, and interdigital electrodes 23f are formed thereon. A ZnO thin film 24f is formed to cover the diamond thin film 22f and the interdigital electrodes 23f, while short-circuit electrodes 26f and a diamond layer 25f are formed thereon. This device was prepared under conditions similar to those in Examples 1 to 3. The structure of the surface acoustic wave device shown in Fig. 12 is hereinafter referred to as a structure F. Characteristic changes caused by variation in thickness of the diamond layer 25f are described later.

Example 8

A surface acoustic wave device shown in Fig. 13 was prepared. The device shown in Fig. 13, which has an Si substrate 21g, a diamond thin film 22g, interdigital electrodes 23g, a ZnO thin film 24g, a diamond layer 25g and short-circuit electrodes 26d, was prepared by providing the short-circuit electrodes on the diamond layer in the device shown in Fig. 11. This device was also prepared under conditions similar to those in Examples 1 to 3. The structure of the surface acoustic wave device shown in Fig. 13 is hereinafter referred to as a structure G. Characteristic changes caused by variation in thickness of the diamond layer 25g are described later.

Example 9

A surface acoustic wave device shown in Fig. 14 was prepared. Referring to Fig. 14, a diamond thin film 22h is formed on an Si substrate 21h, and interdigital electrodes 23h are provided thereon. A ZnO thin film 24h is formed to cover the diamond thin film 22h and the interdigital electrodes 23h, while short-circuit electrodes 26h and a diamond layer 25h are formed thereon. Short-circuit electrodes 26h' are further formed on the diamond layer 25h. This device was also prepared under conditions similar to those in Examples 1 to 3. The structure of the surface acoustic wave device shown in Fig. 14 is hereinafter referred to as a structure H. Characteristic changes caused by variation in thickness of the diamond layer 25h are described later.

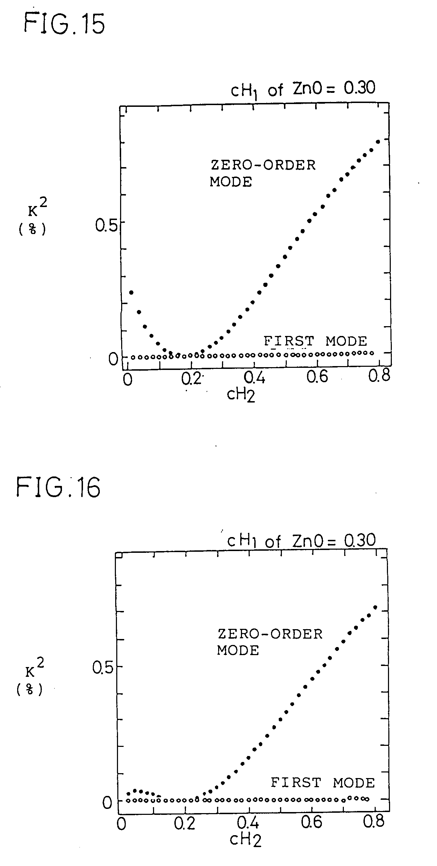

In relation to the structures A to H, Figs. 15 to 30 are graphs showing changes of electromechanical coupling factors caused by variation in thickness of the uppermost diamond layers with prescribed thicknesses of the ZnO thin films. As to the relations between the thicknesses of the diamond layers and the electromechanical coupling factors, the following parameters are employed:

$\lambda$: period of interdigital electrodes (wavelength of surface acoustic wave)

c: $2\pi/\lambda$

$H_1$: thickness of ZnO thin film

$H_2$: thickness of diamond layer

$K^2$: electromechanical coupling factor

Fig. 15 shows the relation between values $cH_2$ and $K^2$, assuming that the value $cH_1$ is 0.30 in the device having the structure B. The values $cH_1$ and $cH_2$ are employed in order to indicate that no change is caused in the relation between the values $K^2$ and $cH_2$ even if the electrode spacing, i.e., the electrode period of the interdigital electrodes is changed.

As understood from Fig. 15, it is possible to increase the electromechanical coupling factor $K^2$ in a zero-order mode to at least 0.3 %, when $cH_1$ = 0.30 and $cH_2 \geq 0.5$ in the structure B. It is also understood from Fig. 15 that the electromechanical coupling factor $K^2$ can be increased as compared with a device provided with no diamond layer ($cH_2$ = 0), if the value $cH_2$ is at least 0.5.

Fig. 16 shows the relation between the values $K^2$ and $cH_2$ assuming that the value $cH_1$ is 0.30 in the device having the structure D. As understood from Fig. 16, it is possible to increase the electromechanical coupling factor $K^2$ in a zero-order mode to at least 0.3 % when $cH_1$ = 0.30 and $cH_2 \geq 0.5$ in the structure D. It is also understood from Fig. 16 that the electromechanical coupling, factor $K^2$ can be increased as compared with a device provided with no diamond layer ($cH_2$ = 0) in a zero-order mode if the value $cH_2$ is made greater than 0.3.

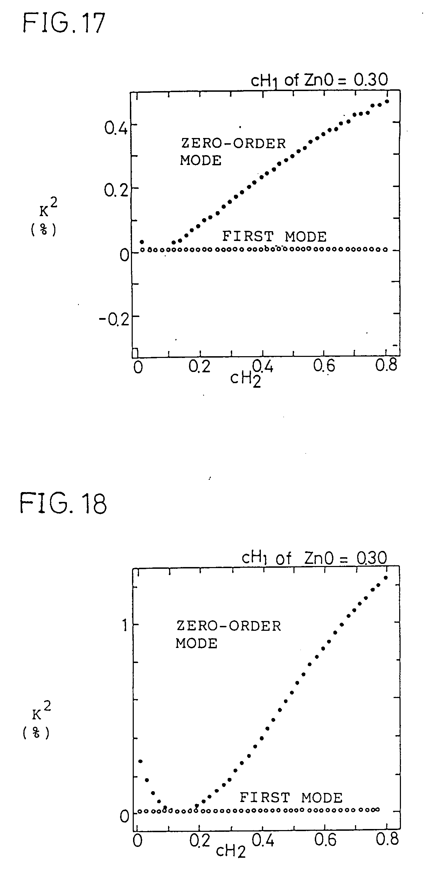

Fig. 17 shows the relation between the values $K^2$ and $cH_2$ assuming that the value $cH_1$ is 0.30 in the device having the structure D. As shown in Fig. 17, it is possible to increase the electromechanical

coupling factor $K^2$ to at least 0.3 % in a zero-order mode when $cH_1$ = 0.30 and $cH_2 \geq 0.5$. Fig. 17 also shows that the electromechanical coupling factor $K^2$ can be increased by forming the diamond layer on the piezoelectric layer.

Fig. 18 shows the relation between the values $K^2$ and $cH_2$ assuming that the value $cH_1$ is 0.30 in the device having the structure F. As shown in Fig. 18, it is possible to increase the electromechanical coupling factor $K^2$ to at least 0.3 % by making the value $cH_2$ at least 0.35. When the value $cH_2$ is greater than 0.35, further, it is possible to increase the electromechanical coupling factor $K^2$ as compared with a device provided with no diamond layer.

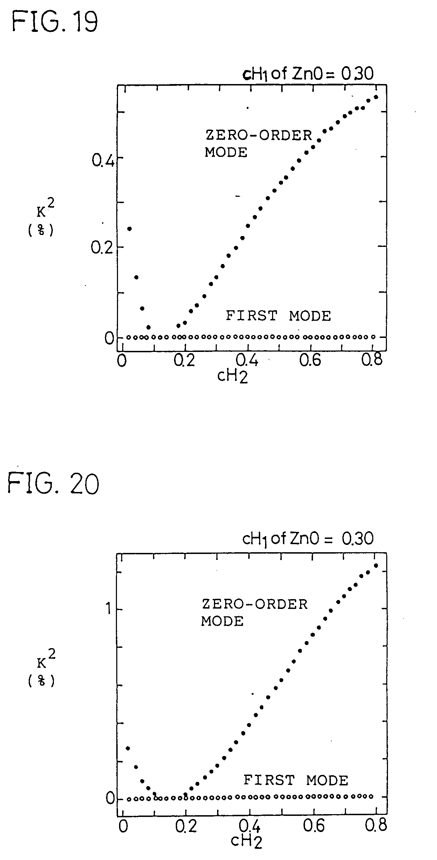

Fig. 19 shows the relation between the values $K^2$ and $cH_2$ assuming that the value $cH_1$ is 0.30 in the device having the structure G. As clearly understood from Fig. 19, it is possible to increase the electromechanical coupling factor $K^2$ to at least 0.3 % in a zero-order mode when $cH_1$ = 0.30 and $cH_2 \geq 0.45$. When the value $cH_2$ is greater than 0.45, the electromechanical coupling factor $K^2$ can be increased as compared with a device provided with no diamond layer.

Fig. 20 shows the relation between the values $K^2$ and $cH_2$ in the device having the structure H. As clearly understood from Fig. 20, it is possible to increase the electromechanical coupling factor $K^2$ to at least 0.3 % in a zero-order mode by making the value $cH_2$ at least 0.35. When the value $cH_2$ is greater than 0.4, the electromechanical coupling factor $K^2$ can be increased as compared with a device provided with no diamond layer.

As to the relation between the values $K^2$ and $cH_2$ in the devices having the structures B, D, E, F, G and H, tendencies equivalent to the above were recognized when the values $cH_1$ were in a range of 0.25 to 0.35.

In each of the aforementioned devices having the structures B, D, E, F, G and H, the diamond thin film provided on the Si substrate was about 25 $\mu$m in thickness. The phase velocity v is increased as the thickness (H) of the diamond thin film defining the lower layer is increased, while such increase of the phase velocity is substantially saturated when the value cH exceeds 4.0. Thus, the diamond thin film defining the lower layer has a sufficient thickness when cH = 4.0.

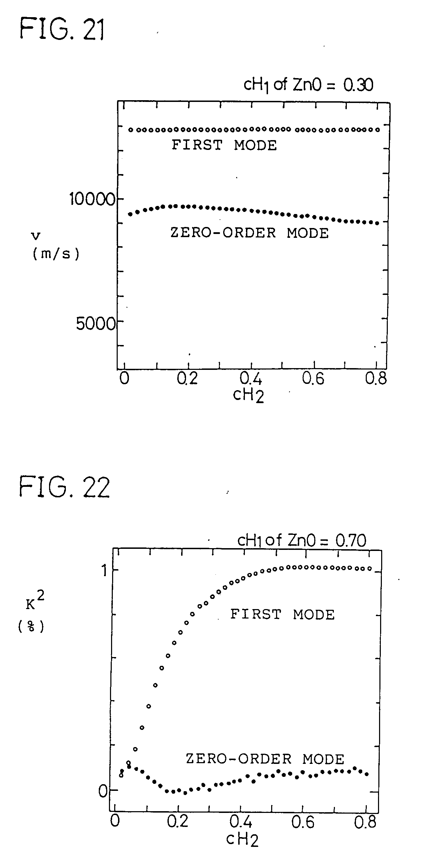

Fig. 21 shows the relation between the phase velocity v and the value $cH_2$ assuming that the value $cH_1$ is 0.30 in each of the surface acoustic wave devices having the structures B, D, E, F, G and H. It is understood from Fig. 21 that high propagation velocities are attained in both zero-order and first modes. It is also understood that the phase velocity is slightly reduced as the thickness of the diamond layer is increased in the zero-order mode, while a sufficiently high phase velocity of about 9,000 m/s is attained when $cH_2 = 0.8$.

Fig. 22 shows the relation between the values $K^2$ and $cH_2$ assuming that the value $cH_1$ is set at 0.70 in another device having the structure A. As shown in Fig. 22, the surface acoustic wave device of the structure A having the value $cH_2$ of at least 0.1 exhibits the electromechanical coupling factor $K^2$ of at least 0.3 % in a first mode. Fig. 22 indicates that the device of the structure A has an electromechanical coupling factor which is higher than that of a conventional surface acoustic wave device having no diamond layer in the first mode.

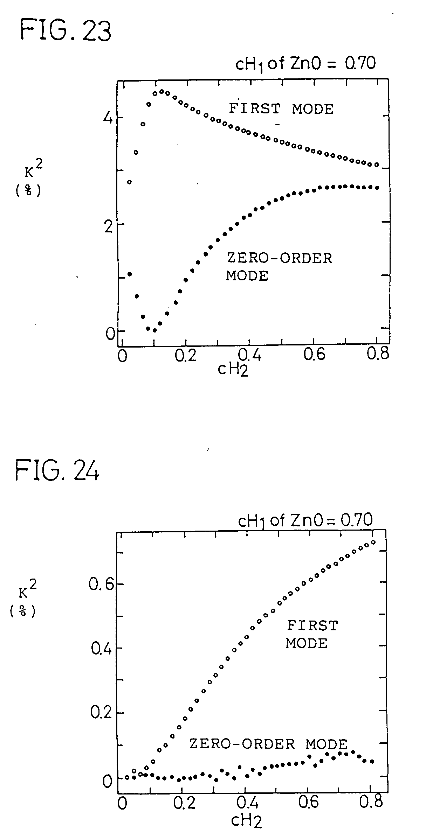

Fig. 23 shows the relation between the values $K^2$ and $cH_2$ assuming that the value $cH_1$ is 0.70 in another device having the structure B. In this case, it is possible to particularly increase the electro-mechanical coupling factor $K^2$ in the first mode by formation of the diamond layer. As shown in Fig. 23, the maximum electromechanical coupling factor $K^2$ is attained when the value $cH_2$ is about 0.1 in the first mode in the device of the structure B having the value $cH_1$ of 0.70. Since an electromechanical coupling factor of 4 to 4.7 % is attained in the first mode, the value $cH_2$ is preferably in a range of 0.07 to 0.30. When the value $cH_2$ is in a range of 0.07 to 1.03, further, it is possible to make the electromechanical coupling factor $K^2$ in a zero-order mode not more than 0.3 %, thereby suppressing unnecessary waves and improving spurious characteristics.

Further, it is possible to increase the electro-mechanical coupling factor $K^2$ in the zero-order mode to 1 to 2.7 % as compared with a device provided with no diamond layer by increasing the value $cH_2$ to at least 0.25.

Fig. 24 shows the relation between the values $K^2$ and $cH_2$ assuming that the value $cH_1$ is 0.70 in another device having the structure C. As shown in Fig. 24, it is possible to increase the electro-chanical coupling factor $K^2$ in a first mode to at least 0.3 % when $cH_1 = 0.70$ and $cH_2 \geq 0.3$. Fig. 24 also shows that the electromechanical coupling factor $K^2$ in the first mode can be increased by formation of the diamond layer, as compared with a device provided with no diamond layer.

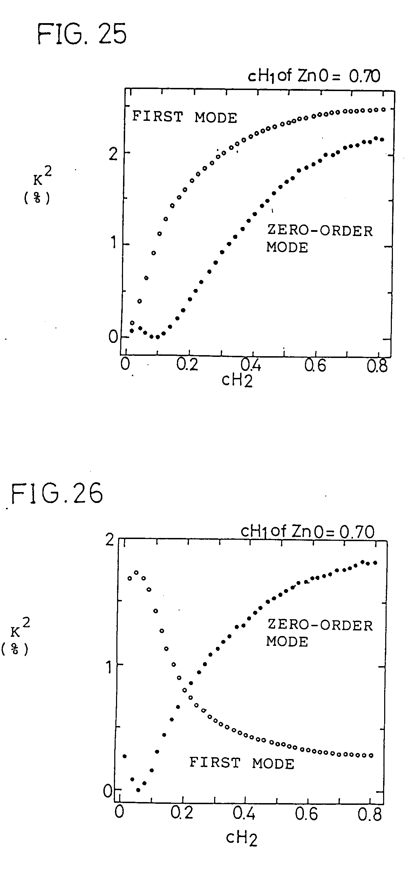

Fig. 25 shows the relation between the values $K^2$ and $cH_2$ assuming that the value $cH_1$ is 0.70 in another device having the structure D. As understood from Fig. 25, it is possible to increase the electromechanical coupling factor $K^2$ in a first mode to 0.3 to 2.5 % when $cH_1 = 0.70$, by making the value $cH_2$ at least 0.05. It is also possible to increase the electromechanical coupling factor $K^2$ in a zero-order mode by making the value $cH_2$ at least 0.2. In order to make excitation only in the first mode, the value $cH_2$ may be set in a range of 0.05 to 0.3 to reduce the electromechanical cou-

pling factor $K^2$ in the zero-order mode.

Fig. 26 shows the relation between the values $K^2$ and $cH_2$ assuming that the value $cH_1$ is 0.70 in another device having the structure E. As shown in Fig. 26, it is possible to increase the electrome-chanical coupling factor $K^2$ in a first mode to 1.5 to 1.7 % while that in a zero-order mode can be reduced to not more than 0.3 % by bringing the value $cH_2$ into a range of 0.02 to 1.00. When the value $cH_2$ is set in this range, it is possible to improve spurious characteristics of the surface acoustic wave device. Further, it is also possible to increase the electromechanical coupling factor $K^2$ in the zero-order mode to at least 0.5 % by making the value $cH_2$ at least 0.15.

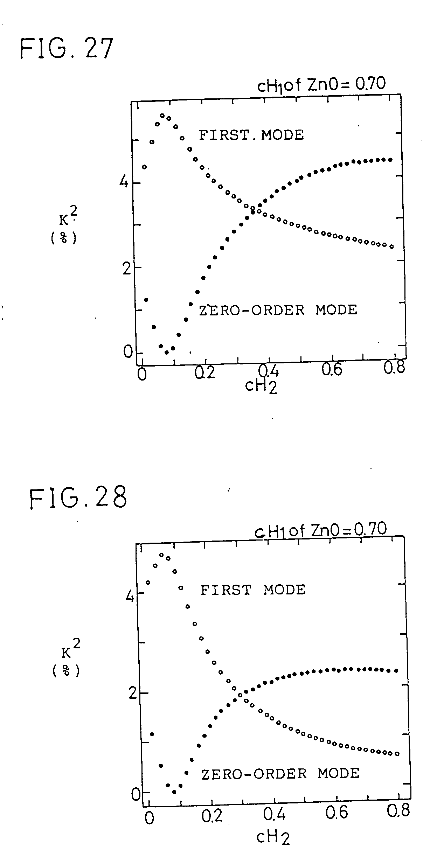

Fig. 27 shows the relation between the values $K^2$ and $cH_2$ assuming that the value $cH_1$ is 0.70 in another device having the structure F. As understood from Fig. 27, it is possible to increase the electromechanical coupling factor $K^2$ in the first mode to 4 to 5.7 % while suppressing that in the zero-order mode by setting the value $cH_2$ in a range of 0.05 to 0.2. When the value $cH_2$ is set in this range, it is possible to provide a surface acoustic wave device having a high electromech-ical coupling factor and excellent spurious characteristics. As to the zero-order mode, on the other hand, it is possible to increase the electromechan-ical coupling factor $K^2$ as compared with a device provided with no diamond layer by making the value $cH_2$ at least 0.2.

Fig. 28 shows the relation between the values $K^2$ and $cH_2$ assuming that the value $cH_1$ is 0.70 in another device having the structure G. It is possible to increase the electromechanical coupling factor $K^2$ in the first mode while suppressing that in the zero-order mode by setting the value $cH_2$ in a range of 0.05 to 0.13. As to the zero-order mode, it is possible to increase the electromechanical cou-pling factor $K^2$ as compared with a device provided with no diamond layer by making the value $cH_2$ at least 0.2.

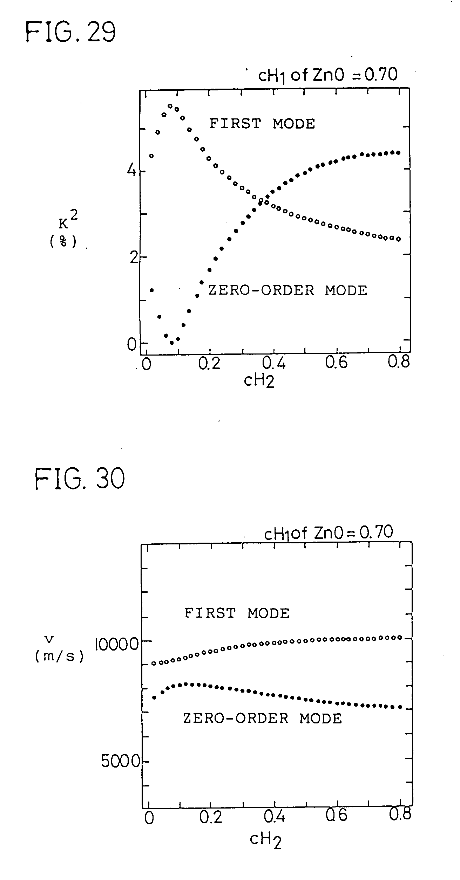

Fig. 29 shows the relation between the values $K^2$ and $cH_2$ assuming that the value $cH_1$ is 0.70 in another device having the structure H. It is possible to provide a surface acoustic wave device having excellent spurious characteristics in the first mode by setting the value $cH_2$ in a range of 0.05 to 0.2. As to the zero-order mode, it is possible to increase the electromechanical coupling factor $K^2$ as compared with a conventional device provided with no diamond layer by making the value $cH_2$ at least 0.2.

In the surface acoustic wave devices having the structures A to H shown in Figs. 22 to 29, effects equivalent to those shown in Figs. 22 to 29 were recognized when the values $cH_1$ were in a range of 0.65 to 0.75.

In each of the devices of the structures A to H having the values $cH_1$ in the range of 0.65 to 0.75, the phase velocity v is also increased as the thickness (H) of the diamond thin film defining the lower layer is increased. However, the diamond thin film may have such a thickness (H) that cH = 4.0, since increase of the phase velocity is substantially saturated when the value cH exceeds 4.0.

Fig. 30 shows the relation between the phase velocity v and the value $cH_2$ assuming that the value $cH_1$ is 0.70 in each of the devices having the structures A to H. As understood from Fig. 30, formation of the diamond layer enables increase of the phase velocity in the first mode as compared with a device provided with no diamond layer. In the case of the first mode, the phase velocity can be further increased by increasing the thickness of the diamond layer, such that a phase velocity of about 10,000 m/s can be attained when $cH_2$ = 0.8.

In a zero-order mode, on the other hand, the phase velocity is slightly reduced as the thickness of the diamond layer is increased, while a sufficiently high phase velocity of 7,000 m/s can be attained when $cH_2$ = 0.8.

While the piezoelectric layer is held between two diamond layers in each of Examples 2 to 9, effects similar to those of each Example can be attained in relation to the electromechanical coupling factor and the phase velocity in any of devices comprising a diamond-like carbon film layer, a piezoelectric layer and another diamond-like carbon film layer, a diamond-like carbon film layer, a piezoelectric layer and a diamond layer, and a diamond layer, a piezoelectric layer and a diamond-like carbon film layer as upper, intermediate and lower layers respectively.

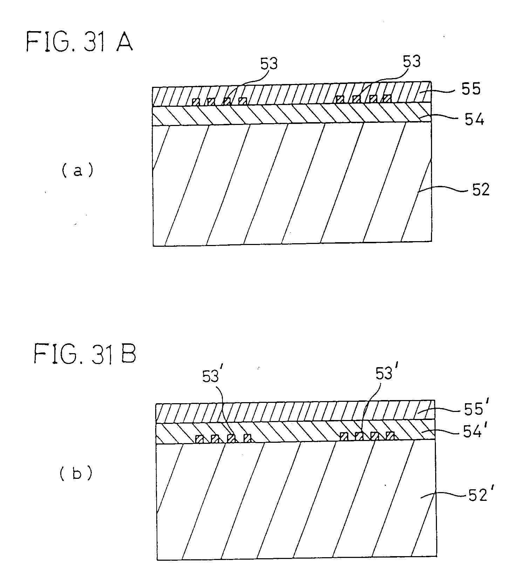

While the diamond thin film is formed on a substrate in each of the aforementioned Examples, a piezoelectric layer may be formed on a diamond substrate as shown in Fig. 31A or 31B, to attain effects similar to those of Examples. Referring to Fig. 31A, a ZnO thin film 54 is formed on a diamond substrate 52. Interdigital electrodes 53 are formed on the ZnO thin film 54, and a layer 55 of diamond or a diamond-like carbon film layer is formed thereon. Referring to Fig. 31B, on the other hand, interdigital electrodes 53' are formed on a diamond substrate 52'. A ZnO thin film 54' is formed to cover the diamond substrate 52' and the interdigital electrodes 53', and a layer 55' of diamond or a diamond-like carbon film is formed thereon.

According to the present invention, as hereinabove described, it is possible to provide a surface acoustic wave device which can perform electromechanical transduction in higher efficiency than a conventional surface acoustic wave device and is employable in an extremely high frequency range. The surface acoustic wave device according to the present invention is particularly applicable to a high-frequency filter which is employed for a communication device such as an automobile telephone or a portable telephone.

Although the present invention has been described and illustrated in detail, it is clearly understood that the same is by way of illustration and example only and is not to be taken by way of limitation, the spirit and scope of the present invention being limited only by the terms of the appended claims.

**Claims**

1. A surface acoustic wave device comprising:
   a first layer being essentially made of at least either diamond or a diamond-like carbon film;
   a piezoelectric layer formed on said first layer;
   a second layer formed on said piezoelectric layer, said second layer being essentially made of at least either diamond or a diamond-like carbon film; and
   an electrode being combined with said piezoelectric layer for making electromechanical transduction.

2. A surface acoustic wave device in accordance with claim 1, wherein said electrode is formed between said first layer and said piezoelectric layer.

3. A surface acoustic wave device in accordance with claim 1, wherein said electrode is formed between said piezoelectric layer and said second layer.

4. A surface acoustic wave device in accordance with claim 2, wherein a short-circuit electrode is formed at least either between said piezoelectric layer and said second layer or on said second layer.

5. A surface acoustic wave device in accordance with claim 3, wherein a short-circuit electrode is formed at least either between said first layer and said piezoelectric layer or on said second layer.

6. A surface acoustic wave device in accordance with claim 2, wherein surface acoustic waves are excited in a zero-order mode having a phase velocity of at least about 7,000 m/s with an electromechanical coupling factor of at least about 0.3 %.

7. A surface acoustic wave device in accordance with claim 3, wherein surface acoustic waves are propagated in a first mode having a phase velocity of at least about 9,000 m/s with an electromechanical coupling factor of at least about 0.3 %.

8. A surface acoustic wave device in accordance with claim 2, wherein said second layer is sufficiently smaller in thickness than said piezoelectric layer, surface acoustic waves being excited in a first mode having a phase velocity of at least about 9,000 m/s with an electromechanical coupling factor of about 0.3 %.

9. A surface acoustic wave device in accordance with claim 1, wherein said electrode is essentially made of diamond containing an impurity being added thereto or a lattice defect being introduced thereinto.

10. A surface acoustic wave device in accordance with claim 1, wherein said piezoelectric layer is essentially made of one or more materials selected from a group of $ZnO$, $A\ell N$, $Pb(Zr,Ti)O_3$, $(Pb,La)(Zr,Ti)O_3$, $LiTaO_3$, $LiNbO_3$, $SiO_2$, $Ta_2O_5$, $Nb_2O_5$, $BeO$, $Li_2B_4O_7$, $KNbO_3$, $ZnS$, $ZnSe$ and $CdS$.

11. A surface acoustic wave device in accordance with claim 1, wherein said first layer is formed on a substrate.

12. A surface acoustic wave device in accordance with claim 1, wherein said first layer is formed by a substrate being essentially made of diamond.

FIG.1

FIG. 2 A

FIG. 2 B

FIG. 2 C

FIG. 2 D

FIG. 3

$$\lambda_0 = 4d$$

|← d →|

FIG. 4

$$\lambda_0 = \frac{8}{3}d$$

|← d →|← d →|

FIG.5

FIG. 6

FIG. 7

(A)

FIG. 8

(B)

FIG. 9

(C)

FIG. 10

(D)

FIG.11

(E)

23e

23e
25e
24e
22e
21e

FIG.12

26f
23f

(F)

25f
26f
24f
23f
22f

21f

FIG.13

26g
23g

(G)

26g
25g
23g
24g
22g
21g

FIG.14

26h
26h
23h

(H)

26h'
25h
26h
24h
23h
22h
21h

FIG.15

cH$_1$ of ZnO = 0.30

K$^2$ (%)

ZERO-ORDER MODE

FIRST MODE

cH$_2$

FIG.16

cH$_1$ of ZnO = 0.30

K$^2$ (%)

ZERO-ORDER MODE

FIRST MODE

cH$_2$

## FIG.17

cH$_1$ of ZnO = 0.30

ZERO-ORDER MODE

FIRST MODE

K$^2$ (%)

## FIG.18

cH$_1$ of ZnO = 0.30

ZERO-ORDER MODE

FIRST MODE

K$^2$ (%)

FIG. 19

FIG. 20

FIG. 21

cH$_1$ of ZnO = 0.30

FIRST MODE

10000

V
(m/s)

ZERO-ORDER MODE

5000

0    0.2    0.4    0.6    0.8
cH$_2$

FIG. 22

cH$_1$ of ZnO = 0.70

K$^2$
(%)

1

FIRST MODE

ZERO-ORDER MODE

0

0    0.2    0.4    0.6    0.8
cH$_2$

FIG. 23

FIG. 24

FIG. 25

FIG.26

FIG. 27

FIG. 28

FIG. 29

FIG. 30

FIG. 31 A

53          53          55
                        54

( a )

52

FIG. 31 B

53'          53'          55'
                          54'

( b )

52'

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-4 952 832 (TAKAHIRO IMAI)<br><br>* the whole document *<br>--- | 1,2,4,5,<br>10,11 | H03H9/02 |
| A | EP-A-0 435 189 (SUMIMOTO)<br>* page 2, column 2, line 50 - page 3,<br>column 1, line 36; figures 23-30 *<br>* page 5, column 7, line 1 - page 5,<br>column 7, line 45 *<br><br>----- | 6-9 | |

TECHNICAL FIELDS
SEARCHED (Int. Cl.5)

H03H

The present search report has been drawn up for all claims

| Place of search | Date of completion of the search | Examiner |
|---|---|---|
| THE HAGUE | 24 NOVEMBER 1992 | COPPIETERS C. |

EPO FORM 1503 03.82 (P0401)